# EUROPÄISCHE PATENTANMELDUNG

(11) **EP 1 889 663 A1**
(43) Veröffentlichungstag der Anmeldung: **20.02.2008**
(21) Anmeldenummer: 07014633.7
(22) Anmeldetag: 26.07.2007
(51) Int. Cl.: B01L 7/00, C23C 14/50, H01L 21/00, H05B 3/00

(54) **Vorrichtung zum Heizen einer Probe**

(30) Priorität: 18.08.2006 DE 102006038925
(71) Anmelder: Forschungszentrum Jülich GmbH, 52425 Jülich (DE)
(72) Erfinder: Hirtz, Kurt, 52459 Inden (DE); Gehlhaar, Reimund, 52428 Jülich (DE); Poppe, Ulrich, 52349 Düren (DE); Emmerich, Matthias, 52428 Jülich (DE); Speen, Rolf, 52428 Jülich (DE)

(57) **Zusammenfassung**

Die Erfindung betrifft eine Vorrichtung zum Heizen einer Probe in einer Apparatur, in welcher ein Hochvakuum einstellbar ist. Diese Vorrichtung umfasst mindestens ein resistives Heizelement, mindestens eine Aufnahme für die Probe sowie mindestens eine das Heizelement und die Aufnahme für die Probe teilweise umgebende Abschirmung. Das Heizelement ist erfindungsgemäß von der Abschirmung durch mindestens ein Isolierstück aus einem bei 1000 °C hochvakuumtauglichen Material beabstandet. Dadurch entfällt die Notwendigkeit, es mit einem nur begrenzt temperaturbeständigen Isoliermaterial zu ummanteln oder in der Vorrichtung zu verlöten. Im Ergebnis können höhere Temperaturen am Ort der Probe erreicht werden, und die Ausgasung von Verunreinigungen wird weitgehend unterbunden.

## Beschreibung

Die Erfindung betrifft eine Vorrichtung zum Heizen einer Probe in einer Apparatur, in welcher ein Hochvakuum einstellbar ist.

### Stand der Technik

Bei der Bearbeitung von Proben im Hochvakuum ist es häufig erforderlich, die Proben auf definierte Temperaturen zu erwärmen. Insbesondere der Verlauf von Wachstumsprozessen dünner Schichten hängt sehr stark von der Temperatur der Probe ab.

Zur Erwärmung von Proben in Sputteranlagen wurde in verschiedenen Instituten des Forschungszentrums Jülich bisher ein Ofen verwendet. Dieser Ofen besteht aus einer Aufnahme für die Probe, in die ein Heizleiter eingelötet ist. Der Heizleiter besteht aus einem dünnen Draht, der sich auf Grund seines elektrischen Widerstands bei Stromdurchfluss erwärmt und so die Aufnahme heizt. Der Draht ist von einem Isoliermaterial umgeben, so dass er nicht in elektrischem Kontakt zu der Aufnahme steht. Die Aufnahme ist teilweise von einer Anordnung aus Strahlungsschilden umgeben, die eine Kühlvorrichtung aufweist.

Nachteilig wird die Isolierung des Heizleiters bei Temperaturen über 1000 °C zerstört, wodurch der Ofen unbrauchbar wird. Schon bei wesentlich geringeren Temperaturen gast der Ofen außerdem im Vakuum Verunreinigungen aus, die sich auf der Probe niederschlagen.

### Aufgabe und Lösung

Aufgabe der Erfindung ist es daher, eine Vorrichtung zum Heizen einer Probe zur Verfügung zu stellen, mit der höhere Temperaturen und eine geringere Ausgasung im Vakuum erzielt werden können als mit dem Ofen gemäß Stand der Technik.

Diese Aufgabe wird erfindungsgemäß gelöst durch eine Vorrichtung gemäß Hauptanspruch. Weitere vorteilhafte Ausgestaltungen ergeben sich aus den darauf rückbezogenen Unteransprüchen.

### Gegenstand der Erfindung

Im Rahmen der Erfindung wurde eine Vorrichtung zum Heizen einer Probe in einer Apparatur, in welcher ein Hochvakuum einstellbar ist, entwickelt. Diese Vorrichtung umfasst mindestens ein resistives Heizelement, mindestens eine Aufnahme für die Probe sowie mindestens eine das Heizelement und die Aufnahme für die Probe teilweise umgebende Abschirmung.

Erfindungsgemäß ist das Heizelement von der Abschirmung durch mindestens ein Isolierstück aus einem bei 1000 °C hochvakuumtauglichen Material beabstandet.

Unter einem bei einer bestimmten Temperatur hochvakuumtauglichen Material im Sinne dieser Erfindung wird ein Material verstanden, dessen Dampfdruck bei dieser Temperatur 10⁻³ mbar oder weniger, insbesondere 10⁻⁶ mbar oder weniger, beträgt. Der niedrige Dampfdruck verhindert, dass Ausgasungen des Materials die Probe verunreinigen.

Es wurde erkannt, dass die Beabstandung des Heizelements mit einem Isolierstück gleich zwei Vorteile gegenüber den als isolierte Kabel ausgeführten Heizleitern nach dem Stand der Technik bietet. Zum einen können mit der erfindungsgemäßen Vorrichtung die Proben auf Temperaturen erwärmt werden, bei denen die Isolierung herkömmlicher Heizleiter zerstört wird. Zum anderen kann das Heizelement starr ausgeführt sein, so dass es nicht mehr durch Löten in der Vorrichtung befestigt werden muss, sondern beispielsweise auch verschraubt werden kann. Lötverbindungen sind insbesondere bei hohen Temperaturen nur bedingt hochvakuumtauglich. Bereits weit unterhalb der Schmelztemperatur steigt der Dampfdruck des Lots stark an, so dass es ausgast und die erwärmte Probe verunreinigt. Diese Verunreinigungen erschweren insbesondere das Aufbringen dünner Schichten auf die Probe.

Unter einem starren Heizelement im Sinne dieser Erfindung wird ein Heizelement verstanden, das an einem beliebigen Punkt seiner Oberfläche aufgehängt werden kann, ohne dabei seine Form wesentlich zu ändern. Ein derartiges Heizelement kann beispielsweise aus einem Blech hinreichender Stärke, beispielsweise 2 mm, ausgeschnitten werden.

Vorteilhaft weist das Heizelement eine Mäanderform auf. Dadurch wird bei vorgegebener beheizbarer Fläche seine Leitungslänge größer, was seinen Widerstand und damit die bei einem gegebenen Heizstrom umsetzbare Heizleistung steigert. Ist das Heizelement aus einem Blech hergestellt, so kann über die Breite der Mäandern der gewünschte Widerstandswert und damit die Heizleistung eingestellt werden.

Die Mäandern sollten durch weitere Isolierstücke gegeneinander beabstandet sein, da sie sich ansonsten bei hohen Temperaturen auf Grund der thermischen Ausdehnung gegenseitig berühren können. Durch einen derartigen Kurzschluss überbrückte Mäandern tragen nichts zur Erwärmung der Probe bei.

In einer besonders vorteilhaften Ausgestaltung der Erfindung besteht das Heizelement aus einem Material, welches beim Hochtemperatureinsatz in Kontakt mit Sauerstoff eine gasdichte Schutzschicht an seiner Oberfläche bildet. Dann kann die Vorrichtung auch in einer oxidierenden Atmosphäre eingesetzt werden. Es sind aber auch nichtmetallische, nicht oxidierende Materialien geeignet, wie etwa Borkarbid.

Vorteilhaft enthält das Heizelement eine Legierung, die mindestens die Legierungselemente Eisen, Chrom und Aluminium umfasst. Eine derartige Legierung kann an ihrer Oberfläche bei hohen Temperaturen unter Einwirkung von Sauerstoff eine Schicht aus Al₂O₃ bilden. Diese Schicht ist gasdicht und verhindert, dass das Material im Inneren weiter oxidiert. Ein Werkstoff mit einer solchen Legierung wird beispielsweise unter dem Handelsnamen Kanthal vermarktet. Die gleiche Wirkung tritt aber auch bei hochwarmfesten Stählen auf, die an ihrer Oberfläche Schutzschichten aus Aluminium- oder Chromoxiden bilden.

Vorteilhaft bestehen das Heizelement und/oder mindestens ein Isolierstück aus einem mittels Laserstrahl schneidbaren Material. Dies vereinfacht die Herstellung gegenüber mechanischer Bearbeitung erheblich. Zudem kann insbesondere ein mäanderförmiges Heizelement durch Laserstrahlschneiden mit einer erheblich höheren Präzision hergestellt werden als durch mechanische Bearbeitung. Weist das Heizelement nach mechanischer Bearbeitung Stellen mit verengtem Querschnitt auf, wird es an diesen Stellen im Betrieb besonders stark wärmebelastet und kann im ungünstigsten Fall durchbrennen.

Vorteilhaft weist die Vorrichtung eine durch die Wandung der Apparatur verlaufende Stromzuführung für das Heizelement auf. Dann ist die Betriebsdauer der Vorrichtung nicht durch einen, etwa in Form einer Batterie, in der Apparatur deponierten endlichen Energievorrat beschränkt. Das Heizelement wird vorteilhaft durch ein lösbares Kopplungsmittel mit der Stromzuführung verbunden. Eine solche Verbindung ist reparaturfreundlicher und gast im Hochvakuum weniger aus als herkömmliche Lötverbindungen.

Unter einem lösbaren Kopplungsmittel im Sinne dieser Erfindung wird ein Kopplungsmittel verstanden, dessen Aggregatzustand auch während des Befestigens und Lösens fest ist. Beispiele für solche Kopplungsmittel sind eine Schraube, eine Klemmverbindung, eine Wicklung aus Draht, ein Bajonettverschluss sowie eine Anordnung aus einem Permanentmagneten und einem ferromagnetischen Gegenstück.

Vorteilhaft ist das Heizelement von der Aufnahme durch mindestens ein weiteres Isolierstück beabstandet. Dann kann es in geringerem Abstand zu dieser Aufnahme angebracht werden, ohne dass es durch thermische Ausdehnung mit dieser Aufnahme in elektrischen Kontakt kommt. Ein geringerer Abstand wiederum steigert die Wärmeabgabe an die Probe und damit die am Ort der Probe erreichbare Maximaltemperatur.

In einer besonders vorteilhaften Ausgestaltung der Erfindung besteht das Isolierstück aus einer Keramik oder einem Metalloxid. Diese Materialien sind hochwarmfest und zeichnen sich durch besonders geringe Dampfdrücke auch bei hohen Temperaturen aus.

Die Abschirmung weist vorteilhaft in mindestens einer Abstrahlrichtung vom Heizelement aus gesehen mindestens eine reflektierende Oberfläche mit einem Reflexionsvermögen von mindestens 0,9 für Nahinfrarot auf. Dann wird der vom Heizelement nicht in Richtung der Probe abgestrahlte Wärmeanteil in Richtung der Probe zurückreflektiert und kommt der Erwärmung der Probe zu Gute. Dieser Effekt wird durch mehrere hintereinander angeordnete reflektierende Oberflächen weiter gesteigert. Eine auf diese Weise effektiver gestaltete Abschirmung steigert nicht nur die Energieeffizienz der Vorrichtung und die am Ort der Probe erreichbare Maximaltemperatur. Sie bewirkt auch, dass andere Komponenten in der Apparatur nicht unnötig wärmebelastet werden und Material ausgasen.

Eine Anordnung mit mehreren reflektierenden Oberflächen lässt sich beispielsweise durch übereinander gestapelte Bleche realisieren, in die jeweils an der gleichen Stelle längliche Löcher eingefräst oder mit einem Laser eingeschnitten sind.

In einer vorteilhaften Ausgestaltung der Erfindung weist die Abschirmung eine Kühlvorrichtung auf. Dies reduziert die Wärmebelastung der Abschirmung und der umgebenden Komponenten in der Apparatur und verringert so auch die Verunreinigung der Probe durch Ausgasungen.

Als Kühlvorrichtung hat sich ein Kühlfinger mit einem Zu- und Ablauf für eine Kühlflüssigkeit bewährt. Ein derartiger Kühlfinger kann so gefertigt werden, dass er nur geschweißte Verbindungen enthält. Es sind für die Versorgung mit Kühlflüssigkeit dann keine gelöteten Wellschlauchverbindungen im Vakuum erforderlich. Wellschlauchverbindungen werden sehr schnell undicht, da die Lötverbindungen durch das Kühlwasser auf die Dauer chemisch angegriffen werden. In die Apparatur eingedrungenes Wasser lässt sich nur schwer wieder vollständig entfernen.

Vorteilhaft ist die Abschirmung durch ein lösbares Kopplungsmittel mit dem Kühlfinger verbunden. Eine solche Anordnung ist reparaturfreundlich, denn es kann beispielsweise die Einheit aus Abschirmung und Heizelement unabhängig vom Kühlfinger ausgetauscht werden, wenn das Heizelement durchgebrannt ist.

Vorteilhaft ist der Kühlfinger in der Wandung der Apparatur beweglich gelagert. Dann kann die Position der Vorrichtung in der Apparatur einfach verändert werden, beispielsweise wenn die Probe beim Aufbringen dünner Schichten auf eine andere Materialquelle auszurichten ist.

In einer vorteilhaften Ausgestaltung der Erfindung enthält die Aufnahme für die Probe mindestens ein Thermoelement zur Temperaturmessung. Insbesondere beim Aufbringen dünner Schichten ist es häufig erforderlich, definierte Temperaturen am Ort der Probe einzustellen und durch Nachregeln der Heizleistung konstant zu halten. Die Aufnahme für die Probe weist dann vorteilhaft mindestens eine Bohrung auf, durch die das Thermoelement geführt ist. Dann kann das Thermoelement bei einem Defekt einfach ausgetauscht werden. Nach dem Stand der Technik war das Thermoelement in der Aufnahme verlötet, so dass es bei einem Ausfall nicht mit vertretbarem Aufwand ausgetauscht werden konnte. Das Thermoelement ist ein Verschleißteil, da es aus mehreren dünnen Drähten besteht und der vollen durch das Heizelement erzeugten Temperatur ausgesetzt ist.

In einer besonders vorteilhaften Ausgestaltung der Erfindung ist die Vorrichtung auf einem Flansch angeordnet, der von außen in die Wandung der Apparatur eingesetzt werden kann. Dann kann die Vorrichtung zu Reparaturzwecken besonders einfach aus der Apparatur ausgebaut und später wieder eingebaut werden. Die Vorrichtung kann außerdem in verschiedene Apparaturen eingesetzt werden unter der einzigen Bedingung, dass ein passender Flansch vorhanden ist.

### Spezieller Beschreibungsteil

Nachfolgend wird der Gegenstand der Erfindung anhand von Figuren näher erläutert, ohne dass der Gegenstand der Erfindung dadurch beschränkt wird. Es ist gezeigt:
Figur 1: Ausführungsbeispiel der erfindungsgemäßen Vorrichtung.
Figur 2: Ausführungsbeispiele des Heizelements 1.

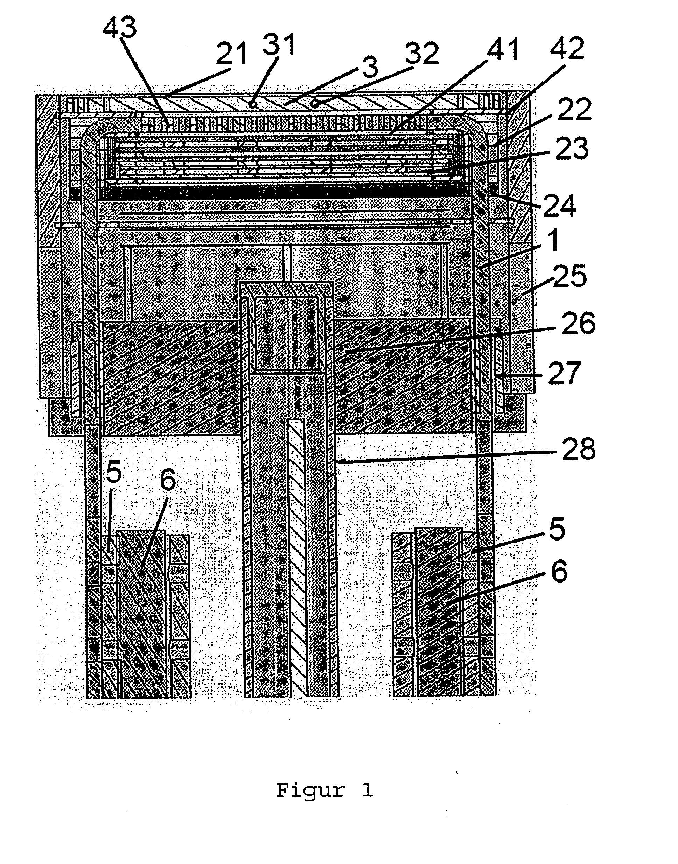

Figur 1 zeigt ein Ausführungsbeispiel der erfindungsgemäßen Vorrichtung in Schnittzeichnung. Das Heizelement 1 ist durch ein Isolierstück 41 aus Al₂O₃ von der Abschirmung beabstandet, die aus einer Strahlblende 21 aus Titan, horizontalen Strahlungsschilden 22, vertikalen Strahlungsschilden 23, einer Bodenplatte 24, einem vergoldeten Kupferkühlschild 25, einer Kühlplatte 26 und einer Kühlklemme 27 aus Aluminiumnitrid besteht. Das Heizelement ist über eine Klemme 5 mit durch die Wandung der Apparatur führenden Stromdurchführungen 6 verbunden. Die Kühlklemme 27 ist wärmeleitfähig, jedoch elektrisch isolierend. Sie verbessert den Wärmekontakt zur Kühlplatte 26 und vermindert die Wärmeeinkopplung aus dem Heizelement 1 in die in Figur 1 nicht eingezeichneten keramischen Isolatoren an den Stromdurchführungen 6. Bei zu hoher Wärmeeinkopplung können diese Isolatoren platzen.

Statt Aluminiumnitrid kann auch Aluminiumoxid als Material für die Kühlklemme verwendet werden. Durch die Kühlklemme sollte nur soviel Wärme abgeführt werden, dass die maximal erreichbare Temperatur am Ort der Probe nicht vermindert wird.

Die horizontalen Strahlungsschilde 22 und die vertikalen Strahlungsschilde 23 weisen jeweils in mindestens einer Abstrahlrichtung vom Heizelement 1 aus gesehen mehrere reflektierende Oberflächen mit einem Reflexionsvermögen von mindestens 0,9 für Nahinfrarot auf. Die horizontalen Strahlungsschilde 22 sind in Form übereinander gestapelter Bleche realisiert, in die jeweils an der gleichen Stelle längliche Löcher mit einem Laser eingeschnitten sind. Der vergoldete Kupferkühlschild 25 ist mit der Kühlplatte 26 verschraubt.

Die Abschirmung umgibt das Heizelement 1 und die Aufnahme 3 für die Probe teilweise. Das Heizelement 1 ist durch ein weiteres Isolierstück 42 von der Aufnahme 3 beabstandet. Die Aufnahme 3 weist Bohrungen 31 und 32 für Thermoelemente auf.

Die Abschirmung weist eine Kühlvorrichtung 28 in Form eines Kühlfingers auf, der mit der Kühlplatte 26 verklemmt ist und in der Wandung der Apparatur beweglich gelagert ist.

Das Heizelement ist mäanderförmig ausgeführt, wobei zwischen seinen Mäandern weitere Isolierstücke 43 angeordnet sind. Dadurch wird verhindert, dass sich die Mäandern infolge thermischer Ausdehnung gegenseitig berühren.

Sowohl die Stromdurchführungen 6 als auch der Kühlfinger 28 und die hier nicht eingezeichneten Durchführungen für das Thermoelement führen durch den Flansch, auf dem die Vorrichtung angeordnet ist.

Mit diesem Ausführungsbeispiel der Vorrichtung können Temperaturen von mindestens 1130 °C am Ort der Probe erreicht werden, ohne dass es zu einer nennenswerten Ausgasung von Verunreinigungen kommt.

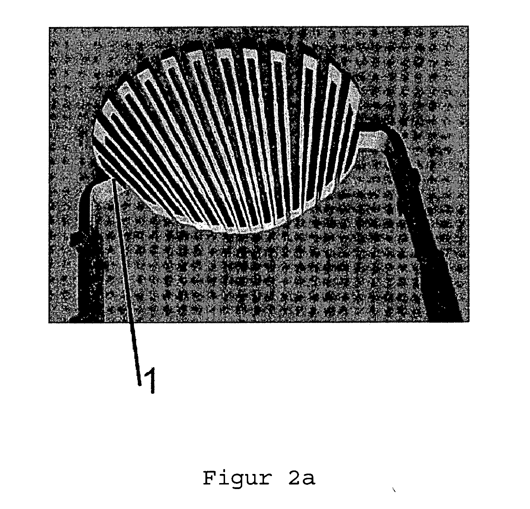

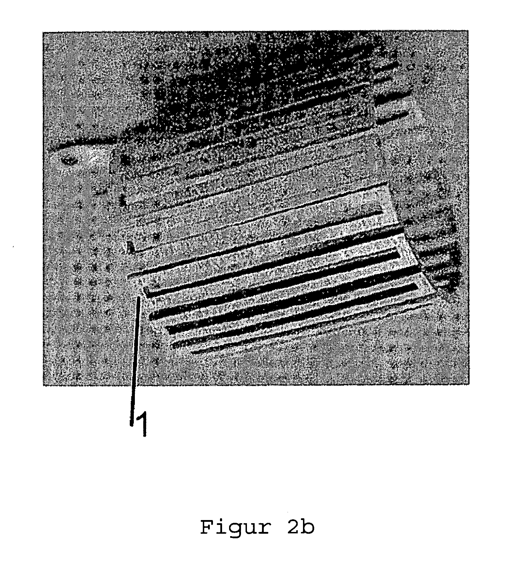

Figur 2 zeigt zwei Ausführungsbeispiele des Heizelements 1.

In Figur 2a weist das Heizelement einen planaren Bereich mit einem mäanderförmigen Verlauf auf. Das Heizelement 1 wurde in diesem Ausführungsbeispiel mit einem Laser in einem Arbeitsgang aus einem Kanthalblech ausgeschnitten; anschließend wurde es zu beiden Seiten des planaren Bereichs gebogen, um über die Klemme 5 mit der Stromdurchführung 6 verbunden werden zu können.

In Figur 2b verläuft das Heizelement auf der Außenfläche eines Zylinders mäanderförmig. Es wurde zunächst in der Ebene mit einem Laser aus einem Kanthalblech ausgeschnitten und anschließend in die zylindrische Form gebogen.

## Patentansprüche

1. Vorrichtung zum Heizen einer Probe in einer Apparatur, in welcher ein Hochvakuum einstellbar ist, umfassend mindestens ein resistives Heizelement, mindestens eine Aufnahme für die Probe sowie mindestens eine das Heizelement und die Aufnahme für die Probe teilweise umgebende Abschirmung,
**dadurch gekennzeichnet,**
**dass** das Heizelement von der Abschirmung durch mindestens ein Isolierstück aus einem bei 1000 °C hochvakuumtauglichen Material beabstandet ist.

2. Vorrichtung nach Anspruch 1, **gekennzeichnet durch** ein starres Heizelement.

3. Vorrichtung nach einem der Ansprüche 1 bis 2, **gekennzeichnet durch** ein Heizelement in Mäanderform.

4. Vorrichtung nach Anspruch 3, **gekennzeichnet durch** Mäandern, die **durch** weitere Isolierstücke gegeneinander beabstandet sind.

5. Vorrichtung nach einem der Ansprüche 1 bis 4, **gekennzeichnet durch** ein Heizelement, welches beim Hochtemperatureinsatz in Kontakt mit Sauerstoff eine gasdichte Schutzschicht an seiner Oberfläche bildet.

6. Vorrichtung nach einem der Ansprüche 1 bis 5, **gekennzeichnet durch** ein Heizelement enthaltend eine Legierung aus mindestens Eisen, Chrom und Aluminium.

7. Vorrichtung nach einem der Ansprüche 1 bis 6, **gekennzeichnet durch** ein Heizelement aus einem mittels Laserstrahl schneidbaren Material.

8. Vorrichtung nach einem der Ansprüche 1 bis 7, **gekennzeichnet durch** mindestens ein Isolierstück aus einem mittels Laserstrahl schneidbaren Material.

9. Vorrichtung nach einem der Ansprüche 1 bis 8, **gekennzeichnet durch** eine **durch** die Wandung der Apparatur verlaufende Stromzuführung für das Heizelement.

10. Vorrichtung nach Anspruch 9, **dadurch gekennzeichnet, dass** das Heizelement durch ein lösbares Kopplungsmittel mit der Stromzuführung verbunden ist.

11. Vorrichtung nach einem der Ansprüche 1 bis 10, **dadurch gekennzeichnet, dass** das Heizelement von der Aufnahme durch mindestens ein weiteres Isolierstück beabstandet ist.

12. Vorrichtung nach einem der Ansprüche 1 bis 11, **gekennzeichnet durch** ein Isolierstück aus einer Keramik oder einem Metalloxid.

13. Vorrichtung nach einem der Ansprüche 1 bis 12, **gekennzeichnet durch** eine Abschirmung, die in mindestens einer Abstrahlrichtung vom Heizelement aus gesehen mindestens eine reflektierende Oberfläche mit einem Reflexionsvermögen von mindestens 0,9 für Nahinfrarot aufweist.

14. Vorrichtung nach einem der Ansprüche 1 bis 13, **gekennzeichnet durch** eine Abschirmung mit einer Kühlvorrichtung.

15. Vorrichtung nach Anspruch 14, **gekennzeichnet durch** einen Kühlfinger mit einem Zu- und Ablauf für eine Kühlflüssigkeit als Kühlvorrichtung.

16. Vorrichtung nach Anspruch 15, **dadurch gekennzeichnet, dass** die Abschirmung durch ein lösbares Kopplungsmittel mit dem Kühlfinger verbunden ist.

17. Vorrichtung nach einem der Ansprüche 15 bis 16, **gekennzeichnet durch** einen in der Wandung der Apparatur beweglich gelagerten Kühlfinger.

18. Vorrichtung nach einem der Ansprüche 1 bis 17, **gekennzeichnet durch** eine Aufnahme für die Probe enthaltend mindestens ein Thermoelement zur Temperaturmessung.

19. Vorrichtung nach Anspruch 18, **gekennzeichnet durch** eine Aufnahme mit mindestens einer Bohrung, **durch** die das Thermoelement geführt ist.

20. Vorrichtung nach einem der Ansprüche 1 bis 19, **dadurch gekennzeichnet, dass** sie auf einem Flansch angeordnet ist, der von außen in die Wandung der Apparatur eingesetzt werden kann.
